Europäisches Patentamt

European Patent Office

Office européen des brevets

(19)

(11) **EP 0 750 231 B1**

(12) **EUROPEAN PATENT SPECIFICATION**

(45) Date of publication and mention
of the grant of the patent:
**20.06.2001 Bulletin 2001/25**

(51) Int Cl.⁷: **G03F 7/20**

(21) Application number: **96302139.9**

(22) Date of filing: **26.03.1996**

(54) **Exposure apparatus and exposure method using the same**

Belichtungsapparat und Belichtungsverfahren unter Verwendung desselben

Appareil d'exposition et méthode d'exposition en faisant usage

(84) Designated Contracting States:
**DE GB NL**

(30) Priority: **19.06.1995 KR 9516257**

(43) Date of publication of application:
**27.12.1996 Bulletin 1996/52**

(73) Proprietor: **SAMSUNG ELECTRONICS CO., LTD.
Suwon-City, Kyounggi-Do 441-370 (KR)**

(72) Inventors:
- **Song, Jae-kwan
  Paldal-gu, Suwon-city, Kyungki-do (KR)**
- **Kim, Jeong-kon
  Paldal-gu, Suwon-city, Kyungki-do (KR)**
- **Bae, Kyung-sung,
  103-207, Keumsung 5-cha Apt.
  Kyungki-do 442-372 (KR)**
- **Park, Kyoung-shin
  Suwon-city, Kyungki-do (KR)**

(74) Representative: **Ertl, Nicholas Justin et al
Elkington and Fife,
Prospect House,
8 Pembroke Road
Sevenoaks, Kent TN13 1XR (GB)**

(56) References cited:
**EP-A- 0 486 316          US-A- 5 396 311**

- **IEICE TRANSACTIONS ON ELECTRONICS,
  MARCH 1994, JAPAN, vol. E77-C, no. 3, ISSN
  0916-8524, pages 432-437, XP000451435
  HO-YOUNG KANG ET AL: "High performance
  lithography with advanced modified
  illumination"**

## EP 0 750 231 B1

**Description**

The present invention relates to an advanced exposure apparatus and an exposure method using the same, and, more particularly, to an illumination system which combines a quadrupole illumination system and an annular illumination system.

When the design rule of a semiconductor device becomes less than 0.35µm, conventional exposure technology using an i-line cannot satisfy the resolution and depth-of-focus requirements for fine pattern formation of the semiconductor device, making it very difficult both to develop a product and to assure mass-production. Various lithography technologies are thus used, which include patterning technology using an advanced exposure apparatus. However, in attempting line pattern formation on a photo sensitive film doped on a stepped structure, a conventional advanced exposure apparatus forms an incomplete line pattern. Furthermore, a proximity effect is generated, whereby the resolutions are different at the center and edges of a formed line; i.e., low resolution results along the edge portion. Most particularly, a contact hole cannot be properly formed by the conventional advanced exposure apparatus.

In the conventional advanced exposure apparatus, because zero-order and +1st-order diffracted beams are used, the resolution and depth-of-focus of exposure apparatus is improved. Theoretically, the resolution of the conventional advanced exposure apparatus is 50% higher than the conventional exposure apparatus, given the same light wavelength (X) and numerical aperture (NA).

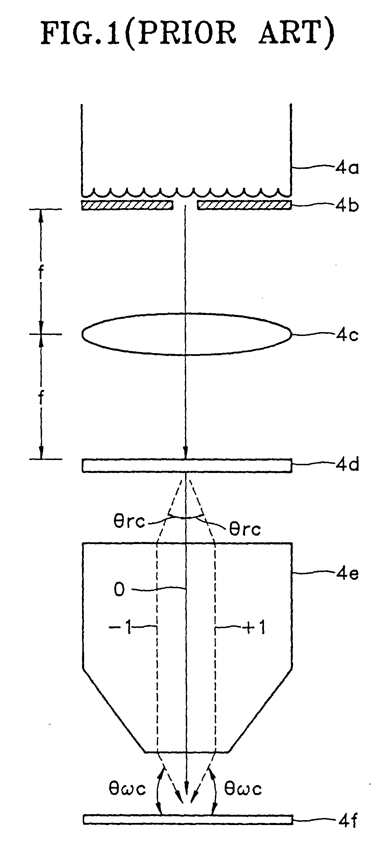

A conventional exposure apparatus including a fly's eye lens, a condenser lens, and a filter between the lenses, and an exposure method using the same, will be explained in detail with reference to Figs. 1-4.

Fig. 1 shows a conventional exposure apparatus whose structure includes a fly's eye lens 4a, a filter 4b, a condenser lens 4c having a focal distance f, a mask pattern 4d and a projection lens 4e. In an illumination method using such an exposure apparatus, after light irradiated from a light source (not shown) passes through lens 4a, the light is limited by filter 4b: filter 4b coincides with a Fourier transform plane of mask pattern 4d via condenser lens 4c.

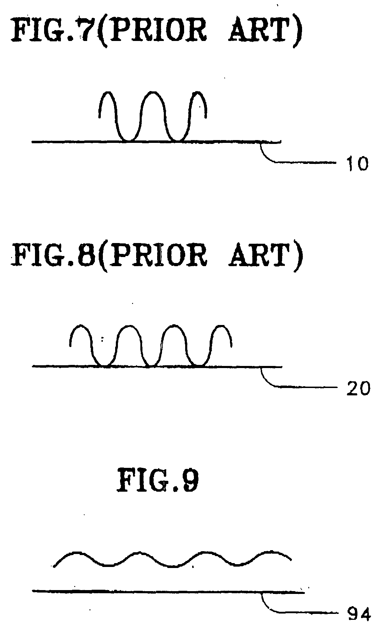

According to the method of Fig. 1, a zero-order (0) diffracted beam of illuminated light on the Fourier transform plane is incident on projection lens 4e vertically, and +1st and -1st order diffracted beams (-1 and +1) are incident on projection lens 4e with an angle of $\theta_{rc}$ (tilted component) as shown in Fig. 1. Accordingly, zero-order, +1st and -1st order diffracted light interfere on a wafer 4f, thereby to reform the intensity distribution of the incident light. As shown in Fig. 7, the light intensity distribution on wafer 4f is a discontinuous distribution, in which a maximum point of light intensity and a minimum point with zero light intensity are clearly distinguished. In Fig. 7, a reference number 10 indicates the wafer.

In Fig. 1, the finer is mask pattern 4d, the more the diffraction angle $\theta_{rc}$ increases. Accordingly, if $\sin\theta_{rc}$ is greater than the NA, non zero-order diffracted light deviates from projection lens 4e, and only the zero-order diffracted light passes through projection lens 4e to arrive at wafer 4f and no interference occurs. At this time, the minimum resolution becomes R=λ/2NA, where X denotes the wavelength of incident light and NA denotes the numerical aperture.

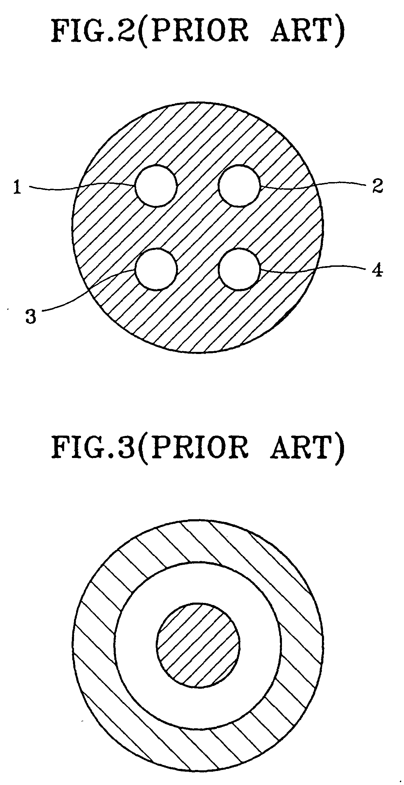

Figs. 2 and 3 show a quadrupole filter and an annular filter used in the conventional advanced exposure apparatus, respectively.

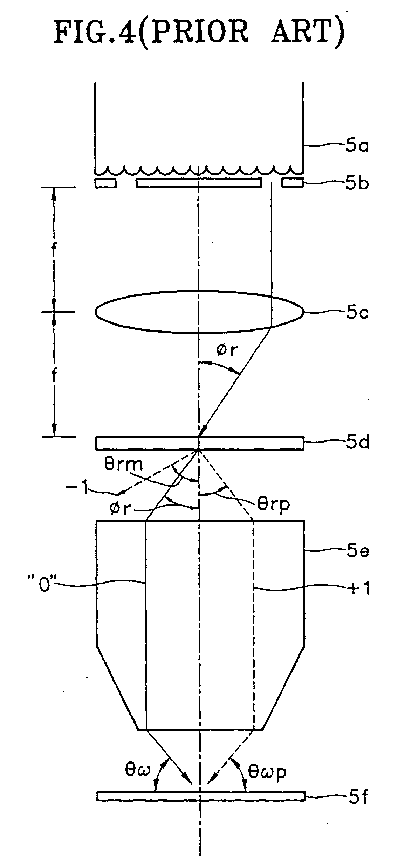

Fig. 4 shows a conventional advanced exposure apparatus using a filter 5b which is different from filter 4b used in the conventional exposure apparatus. While the exposure portion of filter 4b is a central portion of condenser lens 4c in the conventional exposure apparatus, the illumination portion of filter 5b is formed on the edge portion of condenser lens 5c in the conventional advanced exposure apparatus. Accordingly, the light radiated from fly's eye lens 5a is incident on the edge of the lens, initially in parallel with the optical axis of condenser lens 5c. However, on passing through the edge of condenser lens 5c, the light is refracted by condenser lens 5c to be incident on mask pattern 5d at an angle of $\theta_r$ with respect to the optical axis of condenser lens 5c. The angle of diffraction of the light incident on mask pattern 5d is determined by the interval of the pattern. Since the NA of mask pattern 5d is greater than $\sin2\theta_r$, higher order diffracted light not less than -1th order deviates from projection lens 5e, and only zero-order and 1st diffracted light passes through projection lens 5e to arrive at wafer 5f and interfere, resulting in the reformation of an optical energy distribution. As shown in Fig. 8, such a reformed light intensity distribution on the wafer is a continuous distribution but the light intensity between maximum point and minimum point is negligible. In the Fig. 8, reference number 20 represents wafer 5f. The light intensity distribution by the conventional advanced exposure apparatus is generally non-uniform on the wafer.

Since zero-order and +1st order light are uniformly distributed in the neighborhood of the center of projection lens 5e in Fig. 4, phase changes due to defocusing are identical in zero-order and +1st order light and thus there is no phase change to provide a greater depth-of-focus than is obtained by the conventional exposure apparatus. At this time, the resolution becomes R=λ/{2(NA+$\sin\theta_r$)}, and with the expectation of a five times enlargement for the projection, if $\sin\theta_r$=NA/2, the resolution limit of wafer 5f becomes

$$R = \frac{\lambda}{2\left(NA + \frac{NA}{2}\right)}$$

$$= \frac{\lambda}{3NA}$$

and provides a resolution which is 1.5 times the resolution of the conventional exposure apparatus.

As fully described above, in the conventional quadrupole illumination system, the area of the exposure portion of the filter is much smaller than that in stopping down the light of the filter. Accordingly, the exposure time lengthens.

As described above, since the conventional advanced exposure apparatus stops down the part of the light by the filter, the amount of exposure is too small at the time of the advanced exposure, and thus there is a marked increase in exposure time, the illumination apparatus malfunctions and the uniformity of the light intensity distribution lowers. Also, since the light intensity distribution is not uniform on an image formation plane in the conventional advanced exposure apparatus, a considerable amount of the information carried by the light passing through the edge of the mask pattern is lost. Accordingly, a contact hole pattern cannot be formed properly by the conventional advanced exposure apparatus. It is very hard to apply the conventional advanced apparatus to a production field due to asymmetry and the reduction of an edge line and the interval difference between the edge line and the central line of a line pattern because of the proximity effect, to scum generation because of the incomplete removal of photoresist and the formation of an asymmetrical V-shaped notch between lines, and to the degradation of a tilted line and an isolated pattern.

United States patent no. US-A-5,396,311 discloses a filter for use in a projection photolithographic system including a circular light-impervious part for screening the pupil of a projection lens, a ring-like translucent part concentrically contacting the periphery of the circular light-impervious part. Thus, a filter is disclosed which ensures screening on the pupil of the projection lens whilst supplying sufficient energy to improve the resolution of the photolithographic system. "High performance lithography with advanced modified illumination" in IEICE transactions on electronics March 1994, pages 432- 437 discloses a modified illumination technique using an additional grating mask on top of the photomask of a conventional photolithographic system. The technique uses the concept of multipole illumination. European patent application no. EP-A-0,486,316 discloses a projection exposure apparatus having a high resolving power and large focal depth even when using an ordinary retical, by making the illumination light incident on a mask at a predetermined angle relative to the optical axis of the optical system.

It is an object of the present invention to solve the above problems and to provide an advanced exposure apparatus with a combined filter capable of forming a uniform light intensity distribution while the light intensity is maximized in an image formation region.

It is another object of the present invention to provide a method using the advanced exposure apparatus.

According to a first aspect of the present invention an advanced exposure apparatus comprises:

a light source;
an adjusting portion comprising a filter to limit the light emitted from said light source portion;
a refractive/diffractive portion for refracting and diffracting the light emitted from said adjusting portion ; and,
a focusing portion for focusing the light emitted from said refractive/diffractive portion onto a wafer,

characterised in that said filter is provided with a first group of holes and a second group of holes, wherein the size of holes in each group is the same but the distance from the center of the filter differs between the holes of said first group and the holes of said second group and wherein said first group of holes is arranged to provide an annular filter function and said second group of holes is arranged to provide a quadrupole filter function.

According to a second aspect of the present invention an exposure method using an advanced exposure apparatus comprises the steps of:

generating one or more near off-axis light beams and one or more far off-axis light beams from light radiated from a light source;
bringing said near off-axis and far off-axis light beams into oblique incidence on a mask pattern; and
focusing the light emitted from said mask pattern on to a wafer, characterised in that,
said near off-axis light and said far off-axis light are formed by using a filter having a first group of holes and a second group of holes and wherein said first group of holes functions as an annular filter and said second group of holes functions as a quadrupole filter.

Here, the near-off axis light and far-off axis light are both generated by the above filter of the advanced exposure apparatus.

Since a filter of advanced exposure apparatus by the present invention has two off-axis illumination regions. The filter has the same effect as associating a quadrupole filter and annular filter by conventional technology. Therefore, resolution of the advanced exposure apparatus by the present invention is higher than that of a conventional exposure appartus. Also, light intensity becomes uniform on the image formation plane.

Specific embodiments of the present invention are described in detail below, by way of example, with reference to the attached drawings, in which:

Fig. 1 shows a conventional exposure apparatus;

Figs. 2 and 3 respectively show a quadrupole filter and an annular filter for use in conventional advanced exposure apparatus;

Fig. 4 shows a conventional advanced exposure apparatus including a quadrupole or an annular filter;

Fig. 5 shows a filter used in an advanced exposure apparatus of the present invention;

Fig. 6 shows the advanced exposure apparatus according to the present invention;

Fig. 7 and 8 show the exposure intensity distribution of the prior art;

Figs. 9 shows the exposure intensity distribution of the present invention;

Figs. 10-12 are SEM photographs of a contact hole formed by the advanced exposure apparatus of the prior art;

Fig. 13 is a SEM photograph of a contact hole formed by the advanced exposure apparatus of the present invention.

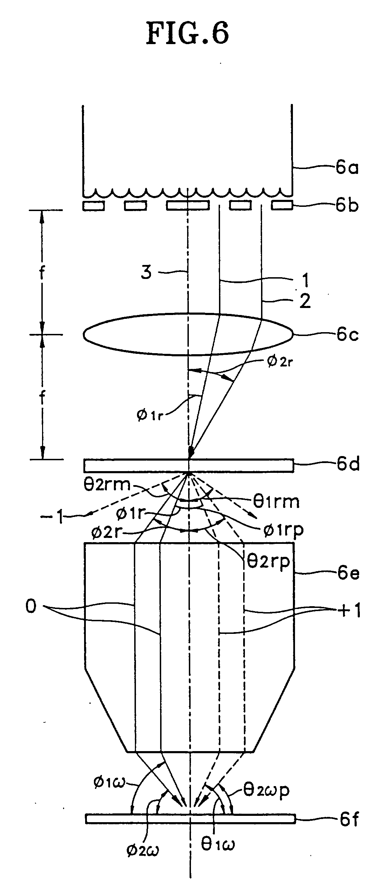

Fig. 6 shows an advanced exposure apparatus according to the present invention. The advanced exposure apparatus of the present invention includes a fly's eye lens 6a for producing collimated light from light coming from a light source, a filter 6b for limiting the light coming from fly's eye lens 6a, a condenser lens 6c with a focal distance of f for refraction at angles ($\Phi_{1r}$ and $\Phi_{2r}$) with respect to optical axis 3 of the light coming from filter 6b, a mask pattern 6d for diffracting the light coming from condenser lens 6c and a projection lens 6e for focusing the light diffracted by mask pattern 6d on a wafer 6f.

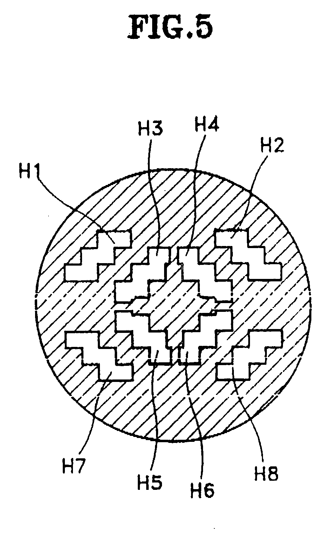

The filter 6b comprise eight exposure holes (see Fig. 5). According to geometric array, the eight holes are divided into two groups of holes, that is, the first group holes (H3, H4, H5, H6) and the second group holes (H1, H2, H7, H8). There are four holes in the first group and four holes in the second group. The four first group holes are formed at a constant distance(hereinafter called the first distance) from the center of the filter and disposed at a fixed angle to each another. The four second group holes are formed at a greater distance(hereinafter called the second distance) than that of the four first group holes from the center of the filter. And, as for the first group holes, the four second group holes are disposed at a fixed angle to each another. The first and the second group holes are of the same form, and the holes are of the same size.

An exposure method employing the advanced exposure apparatus of the present invention will be explained hereinafter. Far off axis light 2 and near off axis light 1 are made incident on mask pattern 6d by condenser lens 6c, and are incident with angles of $\Phi_{1r}$ and $\Phi_{2r}$ respectively with respect to optical axis 3 of condenser lens 6c. Incident light beams 1 and 2 are diffracted by mask pattern 6d to produce two zero-order, two +1st order and two -1st order light beams 0, 1 and -1. The two -1st order light beams are diffracted with angles of $\theta_{1rm}$ and $\theta_{2rm}$ with respect to optical axis 3, thereby to deviate from projection lens 6e. Only two zero-order and two +1st order light beams 0 and 1 are incident upon projection lens 6e. The incident condition is then as follows: the two zero-order beams 0 are incident on projection lens 6e with angles of $\Phi_{1r}$ and $\Phi_{2r}$, respectively, with respect to optical axis 3; the two +1st order light beams 1 are incident on projection lens 6e with angles of $\theta_{1rm}$ and $\theta_{2rm}$, respectively, with respect to optical axis 3, an image of mask pattern 6d is formed at an image formation plane by projection lens 6e: that is, the image of mask pattern 6d is formed on wafer 6f. The resolutions R1 for near axis light (1) and R2 for far axis light (2) can be expressed by the following equations.

$$R1 = \frac{\lambda}{2(NA_r + sin\Phi_{1r})}$$

$$R2 = \frac{\lambda}{2(NA_r + sin\Phi_{2r})}$$

The main equation of the two equations above for determining a resolution limit is R2. Accordingly, it is possible to obtain a resolution greater than the resolution limit for a conventional advanced exposure apparatus by maximizing the light's angle of incidence with respect to mask pattern 6d.

The advanced exposure apparatus of an embodiment of the present invention uses filter 6b, which has more exposure holes than a conventional quadrupole filter, and thus provides a light intensity distribution which is more uniform than that which can be formed on wafer by prior art means.

If the wavelength of the light passing through the filter 6b is λ, the light intensity distribution on wafer 6f is determined by the following equations.

$$d_{12}\sin\theta_{12} = m\lambda \qquad\qquad \ldots(1)$$

$$d_{13}\sin\theta_{13} = m\lambda \qquad\qquad \ldots(2)$$

$$\cdot \qquad\qquad\qquad\qquad\qquad\qquad \cdot$$

$$\cdot \qquad\qquad\qquad\qquad\qquad\qquad \cdot$$

$$\cdot \qquad\qquad\qquad\qquad\qquad\qquad \cdot$$

$$d_{78}\sin\theta_{78} = m\lambda \qquad\qquad \ldots(28)$$

Here, $d_{ij}$ denotes the distance between selected two holes i and j of the eight holes of the filter(see Fig. 5), where i≠j, i={1, 2,..., 8} and j={1, 2,..., 8}, and $\theta_{ij}$ denotes the angle between two light beams coming from the two holes Hi and Hj of the eight holes. Referring to above equations, the condition that the light intensity reaches a maximum on wafer 6f is that m = 1, 2, 3···. Accordingly, the probability that the light intensity at a random point on wafer 6f becomes maximum is $1/2^{28}$. Likewise, the condition that the light intensity reaches a minimum on wafer 6f is when m = M/2, where M is odd number(1, 3, 5, 7,...). Accordingly the probability that the light intensity at a random point on wafer 6f reaches a minimum is $1/2^{28}$, which is the same probability as that of reaching a maximum.

Since the diffractive light of other wavelengths is formed between the maximum and minimum points of the intensity of the diffractive light on wafer 6f, the distribution of the intensity of the diffractive light on wafer 6f is continuous. Accordingly, in the present invention, uniform light intensity distribution over a range considerably wider than that of the conventional advanced exposure apparatus is formed on an image formation plane (wafer 6f). Consequently, although the light intensity of the present invention is slightly lower than that of the conventional advanced exposure apparatus, the uniformity of the light intensity distribution is much greater. Also, the light passing through the center and edge of mask pattern 6d has uniform information for forming an image. Accordingly, even in the case of forming a contact hole pattern, the shape of the contact hole can be very nearly circular. Also, most of the problems generated by proximity effects can be solved.

Fig. 9 shows the distribution of the exposure intensity on wafer 94 by the present invention. With reference to Fig. 9 the light intensity distribution exists even in the region corresponding to the minimum point where the light intensity was zero in the conventional advanced exposure apparatus. The difference between maximum and minimum of the light intensity on the wafer achieved by the embodiment of the present invention is smaller than that achieved for the prior art. Consequently, the light intensity distribution achieved by an exposure method using the advanced exposure apparatus of the present invention is considerably more uniform than that achieved by an exposure method using the conventional advanced exposure apparatus.

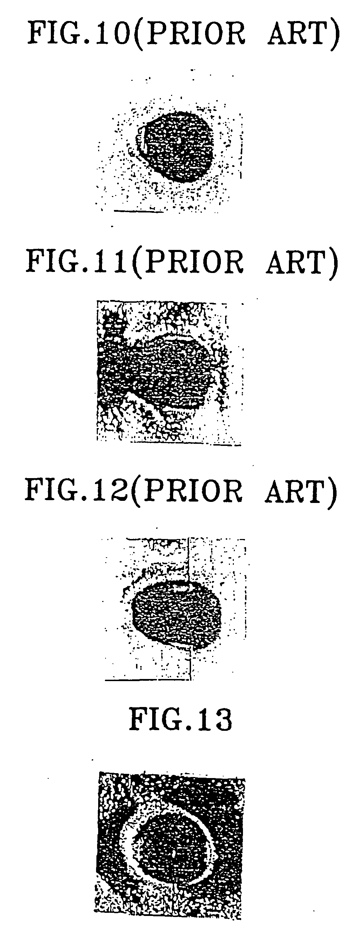

Figs. 10-12 and Fig. 13 are SEM photographs of the contact hole formed by the advanced exposure apparatus of the prior art and of an embodiment of the present invention, respectively. In Figs. 10 and 11, the shape of the contact hole (the central black portion) is somewhat triangular, and, as shown in Fig. 12, the shape is rather elliptical. In Fig. 13, on the other hand, the contact hole formed by the present invention is very nearly circular in shape.

This results as a filter of the embodiment of the advanced exposure apparatus according to the present invention has two off-axis exposure regions. This filter has the same effect as that of associating a quadrupole filter and an annular filter in conventional technology. Therefore, the resolution of the advanced exposure apparatus according to embodiments of the present invention is higher than that of a conventional exposure apparatus. Also, a uniform light intensity distribution can be formed in the image formation plane. Moreover, image formation information of the light passing through the mask pattern approaches uniformity, thereby enabling formation of a contact hole pattern of a nearly circular shape and reducing the proximity effect.

The present invention is not limited to the above embodiment and many alterations can be made by those of ordinary skill of the prior art within the scope of the claims.

**Claims**

1. An advanced exposure apparatus comprising:

   a light source;
   an adjusting portion comprising a filter (6b) to limit the light emitted from said light source portion;
   a refractive/diffractive portion (6c,6d) for refracting and diffracting the light emitted from said adjusting portion (6b) ; and
   a focusing portion (6e) for focusing the light emitted from said refractive/diffractive portion onto a wafer (6f),

   characterised in that said filter (6b) is provided with a first group of holes ($H_3$, $H_4$, $H_5$, $H_6$) and a second group of holes ($H_1$, $H_2$, $H_7$, $H_8$), wherein the size of holes in each group is the same but the distance from the center of the filter differs between the holes of said first group and the holes of said second group and wherein said first group of holes is arranged to provide an annular filter function and said second group of holes is arranged to provide a quadrupole filter function.

2. An advanced exposure apparatus according to claim 1, wherein said first group of holes and said second group of holes are each provided with four holes.

3. An advanced exposure apparatus according to claim 2, wherein for each group of holes said four holes are located with a constant angular relationship to each other.

4. An advanced exposure apparature according to any preceding claim, wherein said first group of holes are holes formed at a first distance from the center of said filter and said second group of holes are holes formed at a second distance from the center of said filter and in which said second distance is greater than said first distance.

5. An exposure method using an advanced exposure apparatus comprising the steps of:

   generating one or more near off-axis light beams and one or more far off-axis light beams from light radiated from a light source;
   bringing said near off-axis and far off-axis light beams into oblique incidence on a mask pattern; and
   focusing the light emitted from said mask pattern on to a wafer, characterised in that,
   said near off-axis light and said far off-axis light are formed by using a filter having a first group of holes and a second group of holes and wherein said first group of holes functions as an annular filter and said second group of holes functions as a quadrupole filter.

6. An exposure method according to claim 5, in which said first group of holes comprises four holes and said second group of holes comprises four holes.

7. An exposure method according to claim 5 or 6, using an advanced exposure apparatus as claimed in any of claims 1 to 4.

**Patentansprüche**

1. Erweiterter Belichtungsapparat umfassend:

   eine Lichtquelle,
   einen Einstellteil umfassend einen Filter (6b), um das von dem Lichtquellenteil emittierte Licht zu begrenzen;
   einen Refraktions-/Diffraktionsteil (6c, 6d) zum Brechen und Beugen des aus dem Einstellteil (6b) emittierten Lichts; und
   einen Fokussierteil (6e) zum Fokussieren des aus dem Refraktions-/Diffraktionsteil emittierten Lichts auf einen Wafer (6f),

   dadurch gekennzeichnet, dass der Filter (6b) mit einer ersten Gruppe von Löchern ($H_3$, $H_4$, $H_5$, $H_6$) und einer zweiten Gruppe von Löchern ($H_1$, $H_2$, $H_7$, $H_8$) versehen ist, worin die Grösse der Löcher in jeder Gruppe gleich ist, aber die Abstände von der Mitte des Filters sich zwischen den Löchern der ersten Gruppe und den Löchern der zweiten Gruppe unterscheiden, und worin die erste Gruppe von Löchern so angeordnet ist, dass sie eine Ringfilterfunktion vorsieht und die zweite Gruppe von Löchern so angeordnet ist, dass sie eine Quadrupolfilterfunktion vorsieht.

**2.** Erweiterter Belichtungsapparat nach Anspruch 1, worin die erste Gruppe von Löchern und die zweite Gruppe von Löchern jeweils mit vier Löchern vorgesehen sind.

**3.** Erweiterter Belichtungsapparat nach Anspruch 2, worin für jede Gruppe von Löchern die vier Löcher mit einem konstanten Winkelverhältnis zueinander angeordnet sind.

**4.** Erweiterter Belichtungsapparat nach einem der vorhergehenden Ansprüche, worin die erste Gruppe von Löchern in einem ersten Abstand zur Mitte des Filters ausgebildete Löcher sind und die zweite Gruppe von Löchern in einem zweiten Abstand zur Mitte des Filters ausgebildete Löcher sind und in dem der zweite Abstand grösser ist als der erste Abstand.

**5.** Belichtungsverfahren unter Verwendung eines erweiterten Belichtungsapparats umfassend die Schritte:

Erzeugen eines oder mehrerer achsnaher Lichtstrahlen und eines oder mehrerer achsferner Lichtstrahlen aus von einer Lichtquelle ausgestrahltem Licht;
die achsnahen und achsfernen Lichtstrahlen in schrägem Einfall auf ein Maskenmuster bringen; und
Fokussieren des vom Maskenmuster emittierten Lichts auf einen Wafer, dadurch gekennzeichnet, dass,
das achsnahe Licht und das achsferne Licht unter Verwendung eines Filters ausgebildet sind, der eine erste Gruppe von Löchern und einen zweite Gruppe von Löchern aufweist, und worin die erste Gruppe von Löchern als Ringfilter funktioniert und die zweite Gruppe von Löchern als Quadrupolfilter funktioniert.

**6.** Belichtungsverfahren nach Anspruch 5, in dem die erste Gruppe von Löchern vier Löcher umfasst und die zweite Gruppe von Löchern vier Löcher umfasst.

**7.** Belichtungsverfahren nach Anspruch 5 oder 6 unter Verwendung eines erweiterten Belichtungsapparats wie er in einem der Ansprüche 1 bis 4 beansprucht ist.

**Revendications**

**1.** Appareil d'exposition perfectionné comprenant :

une source de lumière ;
une partie de réglage comprenant un filtre (6b) pour limiter la lumière émise par ladite partie de source de lumière ;
une partie réfractive/diffractive (6c, 6d) pour réfracter et diffracter la lumière émise par ladite partie de réglage (6b) ; et
une partie de concentration (6e) pour concentrer la lumière émise par ladite partie réfractive/diffractive sur une tranche (6f),

caractérisé en ce que ledit filtre (6b) est doté d'un premier groupe de trous (H3, H4, H5, H6) et d'un second groupe de trous (H1, H2, H7, H8), dans lequel la dimension des trous dans chaque groupe est la même mais la distance par rapport au centre du filtre diffère entre les trous dudit premier groupe et les trous dudit second groupe et dans lequel ledit premier groupe de trous est agencé de manière à exécuter une fonction de filtrage annulaire et ledit second groupe de trous est agencé de manière à exécuter une fonction de filtrage quadripôle.

**2.** Appareil d'exposition perfectionné selon la revendication 1, dans lequel ledit premier groupe de trous et ledit second groupe de trous sont chacun dotés de quatre trous.

**3.** Appareil d'exposition perfectionné selon la revendication 2, dans lequel, pour chaque groupe de trous, lesdits quatre trous sont disposés avec une relation angulaire constante entre eux.

**4.** Appareil d'exposition perfectionné selon l'une quelconque des revendications précédentes, dans lequel ledit premier groupe de trous est constitué de trous formés à une première distance du centre dudit filtre et ledit second groupe de trous est constitué de trous formés à une seconde distance du centre dudit filtre et dans lequel ladite seconde distance est supérieure à ladite première distance.

5.  Procédé d'exposition utilisant un appareil d'exposition perfectionné comprenant les étapes consistant à :

produire un ou plusieurs faisceaux de lumière légèrement en dehors de l'axe et un ou plusieurs faisceaux de lumière largement en dehors de l'axe à partir de la lumière rayonnée par une source de lumière ; amener lesdits faisceaux de lumière légèrement en dehors de l'axe et largement en dehors de l'axe en incidence oblique sur un motif de masque ; et concentrer la lumière émise par ledit motif de masque sur une tranche, caractérisé en ce que, ladite lumière légèrement en dehors de l'axe et ladite lumière largement en dehors de l'axe sont formées en utilisant un filtre comportant un premier groupe de trous et un second groupe de trous et dans lequel ledit premier groupe de trous agit comme un filtre annulaire et ledit second groupe de trous agit comme un filtre quadripôle.

6.  Procédé d'exposition selon la revendication 5, dans lequel ledit premier groupe de trous comprend quatre trous et ledit second groupe de Lrous comprend quatre trous.

7.  Procédé d'exposition selon la revendication 5 ou 6, utilisant un appareil d'exposition perfectionné selon l'une quelconque des revendications 1 à 4.

# FIG.1(PRIOR ART)

# FIG.2(PRIOR ART)

1

2

3

4

# FIG.3(PRIOR ART)

# FIG.4(PRIOR ART)

# FIG.5

# FIG.6

EP 0 750 231 B1

## FIG.7(PRIOR ART)

— 10

## FIG.8(PRIOR ART)

— 20

## FIG.9

— 94

14

## FIG.10(PRIOR ART)

## FIG.11(PRIOR ART)

## FIG.12(PRIOR ART)

## FIG.13